# EUROPEAN PATENT SPECIFICATION

(11) **EP 2 700 999 B1**
(45) Date of publication and mention of the grant of the patent: **22.08.2018**
(21) Application number: 13173445.1
(22) Date of filing: 24.06.2013
(51) Int. Cl.: G02F 1/1335

(54) **Liquid crystal display panel, method for fabricating the same and liquid crystal display device**
Flüssigkristallanzeigetafel, Herstellungsverfahren dafür und Flüssigkristallanzeigevorrichtung
Panneau d'affichage à cristaux liquides, son procédé de fabrication et dispositif d'affichage à cristaux liquides

(30) Priority: 20.08.2012 CN 201210297468
(43) Date of publication of application: 26.02.2014
(73) Proprietor: Beijing BOE Optoelectronics Technology Co., Ltd., Beijing 100176 (CN)
(72) Inventor: Guo, Renwei, 100176 Beijing (CN); Xie, Jianyun, 100176 Beijing (CN)
(74) Representative: Brötz, Helmut

(56) References cited:
- JP-A- 2004 069 826
- US-A1- 2004 169 797
- US-A1- 2005 134 771
- US-A1- 2005 140 916
- US-A1- 2008 079 876
- US-A1- 2009 161 049

## Description

### FIELD OF THE ART

Embodiments of the invention relate to a liquid crystal display (LCD) area, more specifically, to a LCD panel, a method for fabricating the same and a display device.

### BACKGROUND

Backlight modules are generally used to light sources for conventional LCDs, the brightness of which is thus dependent on the backlight source. The later-proposed reflective LCD displays images by reflecting ambient light, and the intensity of the ambient light may affect the displayed brightness. For the purpose of overcoming the disadvantage of being dependent on the ambient light of the reflective LCD, a transflective display mode is proposed, in which part of the light comes from the ambient light and part of the light is provided by the backlight.

The display unit of a transflective LCD therefore inevitably comprises two parts, that is, a reflective region for reflecting the ambient light and a transmissive region for transmitting the backlight. The inventors found the following disadvantage in the conventional technology through research: the two lights from different sources may cause different optical path length for the two light sources, if no corresponding design is performed on the display structure. The difference in the optical path length may further render different display effects for the two display modes, thereby negatively influencing the display effect and the user experiences. In the prior art it is known from US 2005/140916 A1 a liquid crystal display device and fabrication method therefore. US 2008/0079876 A1 discloses a liquid crystal display. From US 2009/0161049 A1 it is known a liquid crystal display device.
US 2005/0134771 A1 discloses a vertical alignment mode reflective-transmissive liquid crystal display with multi-cell gap. JP 2004/069826 A discloses an electro-optical apparatus and electronic equipment.
From US 2004/0169797 A1 it is known an electro optical panel and electronic equipment.

### SUMMARY

Embodiments of the invention provide a liquid crystal display panel, its fabrication method, and a LCD device.

In one aspect, the present invention provides an LCD according to the subject-matter of claim 1.

As an example, the reflection layer is a metal layer.

As an example, the metal layer is an aluminium layer.

As an example, the reflection layer covers a part of the surface of the array substrate.

As an example, liquid crystals in the liquid crystal layer are negative liquid crystals, and electron-withdrawing groups in the negative liquid crystals are in a short axis of the liquid crystals.

As an example, the negative liquid crystals are fluorine-based derivatives having rigid groups in the molecular structure.

As an example, the protrusion has a flat surface.

In another aspect, the invention further provides a LCD device comprising the above LCD panel.

In another aspect, the invention further provides a method for fabricating an LCD device according to the subject-matter of claim 9.

As an example, the step of forming a color filter substrate having a protrusion disposed on a surface of which comprises:
forming a black matrix pattern on a color filter base substrate;
forming a color filter layer on the black matrix pattern; and
depositing a resin layer on the color filter layer and forming a protrusion by using the patterning process.

As an example, the step of forming an array substrate having a reflection layer disposed on a surface of which comprises:
sequentially forming a pattern comprising a common electrode and a gate electrode, a first insulating layer and a passivation layer on an array base substrate by using the patterning process;
forming a pattern including data line and the source/ drain electrode, and the second insulating layer on the passivation layer by using the patterning process; and
forming a reflection layer on the second insulating layer by using the patterning process.

As an example, the method further comprises:
forming a via hole on the second insulating layer; and
forming a second electrode layer on the reflection layer, the second electrode layer is connected to the source/ drain electrode through the via hole.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.
Fig. 1 schematically illustrates a configuration of a LCD panel in accordance with an embodiment of the invention;
Fig. 2 schematically illustrates a LCD panel at power-off state in accordance with an embodiment of the invention;
Fig. 2a illustrates the optical principle of the reflective region at power-off state in accordance with an embodiment of the invention;
Fig. 2b illustrates the optical principle of the transmissive region at power-off state in accordance with an embodiment of the invention;
Fig. 3 schematically illustrates a LCD panel at power-on state in accordance with an embodiment of the invention;
Fig. 3a illustrates the optical principle of the reflective region at power-on state in accordance with an embodiment of the invention;
Fig. 3b illustrates the optical principle of the transmissive region at power-on state in accordance with an embodiment of the invention;
Fig. 4 schematically illustrates a flow chart of processes for fabricating a color filter substrate in accordance with an embodiment of the invention;
Fig. 4a to 4e schematically illustrate configurations for fabricating a color filter substrate with a protrusion in accordance with an embodiment of the invention;
Fig. 5 schematically illustrates a flow chart of processes for fabricating an array substrate in accordance with an embodiment of the invention;
Fig. 5a to 5f schematically illustrate configurations for fabricating an array substrate with a reflective layer in accordance with an embodiment of the invention; and
Fig. 6 is the molecular formulas of negative liquid crystals used in a LCD panel in accordance with an embodiment of the invention.

### Description of numeral references:

10: color filter substrate; 11:color filter base substrate, 12: black matrix; 13: color filter layer; 14: protrusion; 15: ITO electrode; 16: post spacer; 17:compensation film; 18: λ /4 plate; 19: upper polarizer; 20: array substrate; 21: array base substrate; 22: gate electrode; 23: first insulating layer; 24: passivation layer; 25: source/drain electrode; 26: second insulating layer; 27: first alignment film; 28: second alignment film; 29: lower polarizer; 30: liquid crystal layer; 31: reflection layer.

### DETAILED DESCRIPTION

In order to make objects, technical details and advantages of the embodiments of the invention apparent, the technical solutions of the embodiment will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

An embodiment of the invention provides a LCD panel, a LCD device and a method for fabricating the same which makes the optical path length of the reflective light source and the transmissive light source the same, thereby improving the display effect of the LCD device.

### Embodiment 1

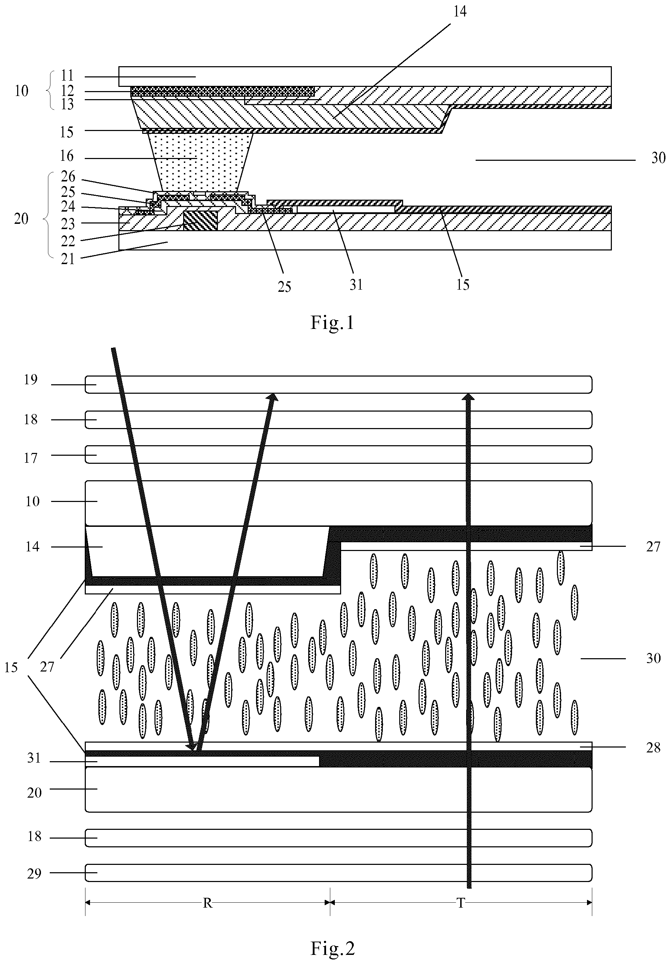

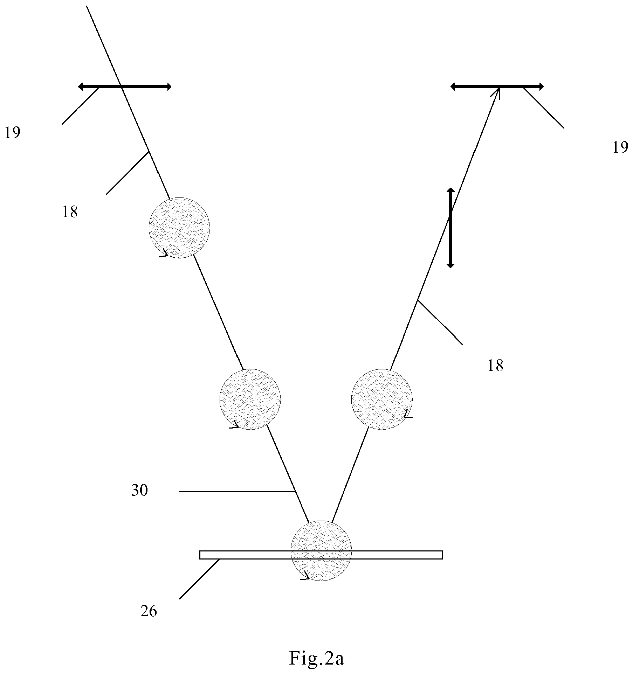

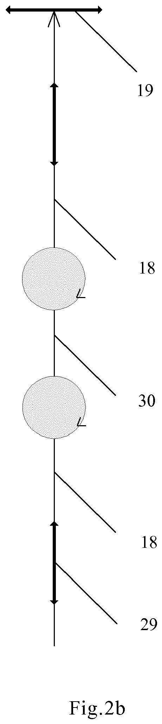

An embodiment of the invention provides a LCD panel as illustrated in Fig. 1, which comprises: a color filter substrate 10, an array substrate 20 and a liquid crystal layer 30 disposed between the color filter substrate 10 and the array substrate 20. A protrusion 14 with a height of half the thickness of the liquid crystal layer 30 is disposed on the surface of the color filter substrate 10, facing the liquid crystal layer 30. The surface of the protrusion 14 is flat. The thickness of liquid crystal layer 30 is a distance between the color filter substrate 10 and the array substrate 20 and also referred to as 'cell gap'. The LCD panel according to the embodiment of the invention divides the display region of a pixel into a reflective region R and a transmissive region T by disposing the protrusion 14 on the color filter substrate 10. As illustrated in Fig. 2, the reflective region R is a liquid crystal layer region that corresponds to the protrusion and the reflective layer pattern, and the transmissive region R is a liquid crystal layer region that does not correspond to the protrusion and the reflective layer pattern. The height of the protrusion is half the thickness of the liquid crystal layer (i.e., the cell gap), therefore, the height of the liquid crystal layer at the reflective region is half the thickness of the liquid crystal layer (i.e., the cell gap), while the thickness of the liquid crystal layer at the transmissive region is the same as the thickness of the liquid crystal layer. By this means, when the reflected light enters the reflective region and is reflected by the reflective layer and passes through the reflective region for a second time, the optical path length of the reflected light is the same as that of the transmitted light in the transmissive region. A reflective layer 31 is disposed on the surface of the array substrate 20 facing the liquid crystal layer 30, and the reflective layer 31 is opposite to the protrusion 14, thereby ensuing that the light from the ambient light source is only reflected in the reflective region.

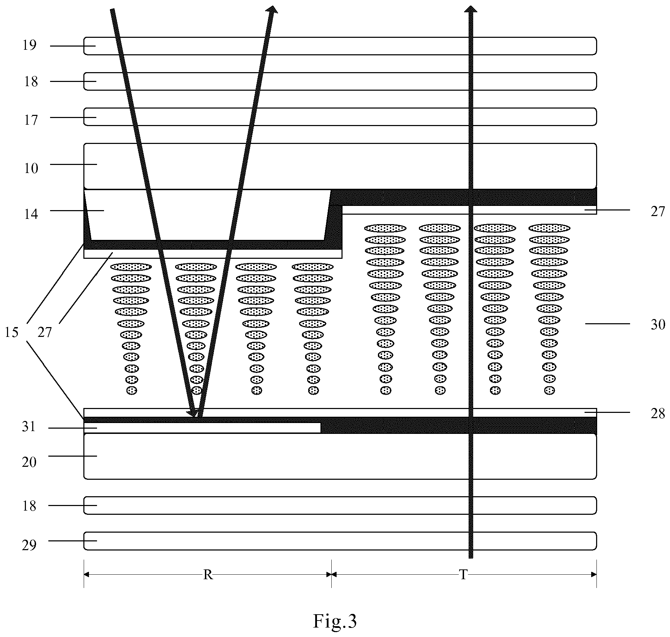

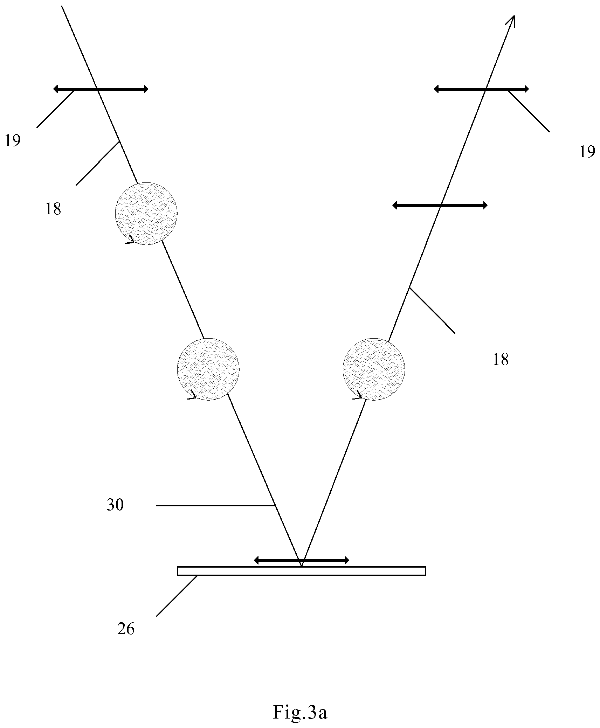

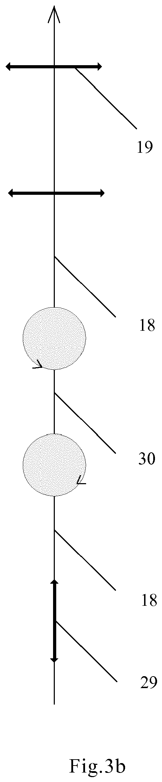

Figs. 2 and 3 schematically illustrate configurations of the LCD panel at power-off and power-on states in accordance with the embodiment of the invention. The display principle of the display panel will be further described in connection with Figs. 2 and 3 in the following.

In the above embodiment of the invention, absorbing axes of the upper and lower polarizers are vertical to each other and alignment directions of the first and second alignment film layers are also vertical to each other, where the absorbing axis of the upper polarizer is the same as the alignment direction of the first alignment film layer. As illustrated in Fig. 2, the first alignment film layer 27 is disposed on a surface of the protrusion 14 facing the liquid crystal layer 30, and the second alignment layer 28 is disposed on a surface of the reflective layer 31 facing the liquid crystal layer 30.

When power is off, as illustrated in Fig. 2, the liquid crystal molecules are aligned vertical to the substrate under the effect of the alignment film layer. In this case, the liquid crystal molecules will not perform an optical delay operation to the light, and the polarization directions of both lights travelling in the reflective region and the transmissive region are vertical to the transmitting axis of the upper polarizer. As a result, no light can pass through the upper polarizer and both the transmissive region and the reflective region are dark.

The procedure of light variation in the reflective region and the transmissive region when power is off will be explained with reference to Figs. 2a and 2b. The procedure of light variation in the reflective region when power is off is illustrated in Fig. 2a. In the reflective region R, the transmission axis of the upper polarizer 19 is in the horizontal direction and the ambient light produces a linear polarized light along the horizontal direction after transmitting through the polarizer. The horizontally polarized light is then turned into a left-handed circularly polarized (LHCP) light by the λ/4 plate 18. Due to that the liquid crystals are aligned vertically, the liquid crystal layer in the reflective region does not affect the LHCP light. The LHCP light is reflected by the reflection layer 31 to form a right-handed circularly polarized (RHCP) light. The RHCP light is turned into a linear polarized light in the vertical direction by the λ/4 plate 18. At this point, the polarization direction of the linear polarized light is vertical to the transmission axis of the upper polarizer 19 and no light can pass through the upper polarizer. As a result, the reflective region is dark.

The procedure of light variation in the transmissive region when power is off is illustrated in Fig.2b. In the transmissive region T, a linear polarized light in the vertical direction is produced by the lower polarizer 29 from the light of the backlight source. The linear polarized light is turned into a RHCP light by the λ/4 plate 18. Due to that the liquid crystals are aligned vertically, the liquid crystal layer in the transmissive region does not affect the RHCP light. The RHCP light is turned into a linear polarized light in the vertical direction by the λ/4 plate. At this point, the polarization direction of the linear polarized light is vertical to the transmission axis of the upper polarizer and no light can pass through the upper polarizer. As a result, the transmissive region is dark.

As illustrated in Fig. 3, when power is on, due to the liquid crystals are negative liquid crystals, the long axes of the liquid crystal molecules are spirally aligned parallel to the substrate under the influence of the electric field. The twisted liquid crystal molecules will perform optical delay operation on the light. Due to that the thickness of the liquid crystal layer in the transmissive region is twice that of liquid crystal layer in the reflective region, when the liquid crystal layer in the reflective region causes λ/4 delay on the light, the liquid crystal layer in the transmissive region will definitely cause λ/2 delay on the light. The polarization directions of both the lights passing through the reflective region and the transmissive region are parallel to the transmission axis of the upper polarizer, thus the light can pass through the polarizer and both the transmissive region and the reflective region are bright.

The procedure of light variation in the reflective region and the transmissive region when power is on will be explained with reference to Figs. 3a and 3b. The procedure of light variation in the reflective region when power is on is illustrated in Fig. 3a. In the reflective region R, the transmission axis of the upper polarizer 19 is in the horizontal direction and the ambient light produces a linear polarized light along the horizontal direction after passing through the polarizer. The horizontally polarized light is turned into a LHCP light by the λ/4 plate 18. When power is on, the liquid crystal molecules in the reflective region causes a λ/4 delay on the light and the LHCP light is transformed into a linear polarized light in the horizontal direction, which remains a linear polarized light in the horizontal direction after being reflected by the reflective region 31. Again the liquid crystal molecules in the reflective region under power-on state causes a λ/4 delay on the light and the linear polarized light in the horizontal direction is transformed into a LHCP light. The LHCP is then turned into a linear polarized light in the horizontal direction after passing through the λ/4 plate. At this point, the polarization direction of the linear polarized light is parallel to the transmission axis of the upper polarizer and light can pass through the upper polarizer. As a result, the reflective region is bright.

The procedure of light variation in the transmissive region when power is on will be explained with reference to 3b. In the transmissive region T, a linear polarized light in the vertical direction is produced by the lower polarizer 29 from the light of the backlight source. The linear polarized light is turned into a RHCP light by the λ/4 plate 18. Under power on-state, the liquid crystal molecules in the transmissive region cause a λ/2 delay on the light and the RHCP light is transformed into a LHCP light. The LHCP light is then turned into a linear polarized light in the horizontal direction by the λ/4 plate. At this point, the polarization direction of the linear polarized light is parallel to the transmission axis of the upper polarizer and light can pass through the upper polarizer. As a result, the transmissive region is bright.

In the above, the light variations in the reflective and the transmissive regions of the LCD panel under both power-on and power-off states are described. It may be found that the light in the reflective region and the transmissive region of the display panel under both power- on and power- off has a synchronous effect.

In the LCD panel according to the embodiment of the invention, the lights from both light sources are made to travel through equal optical distance by disposing the protrusion on the surface of the color filter substrate facing the liquid crystal layer and disposing the reflection layer on the surface of the array substrate facing the liquid crystal layer. The LCD panel in accordance with the embodiment of the invention is neat and clever, which optimizes the display performance of the LCD panel and significantly improves the display effect to provide a better user experiences for the customers.

Optionally, a post spacer 16 with a height of for example a half of the thickness of the liquid crystal layer may be disposed between the color filter substrate 10 and the array substrate 20. The post spacer 16 is positioned under the protrusion and penetrates through the liquid crystal layer, such that the two substrates of the display panel are supported and the gap of the whole liquid crystal layer is kept constant.

Optionally, an electrode layer 15 (e.g., indium tin oxides (ITO)) may be disposed on the surfaces of both the protrusion and the reflection layer facing the liquid crystal layer, a first alignment film layer 27 is disposed on the surface of the ITO electrode layer of the color filter substrate facing the liquid crystal layer, and a second alignment film layer 28 is disposed on the surface of the ITO electrode layer of the array substrate facing the liquid crystal layer.

Optionally, a compensation film 17, the λ/4 plate 18 and the upper polarizer 19 are sequentially disposed on the surface of the color filter substrate opposed to the liquid crystal layer, and the λ/4 plate 18 and the lower polarizer 29 are sequentially disposed on the surface of the array substrate opposed to the liquid crystal layer.

In the embodiment, the reflection layer 31 is for example a metal layer, which may be for example an aluminum layer partially covering the array substrate.

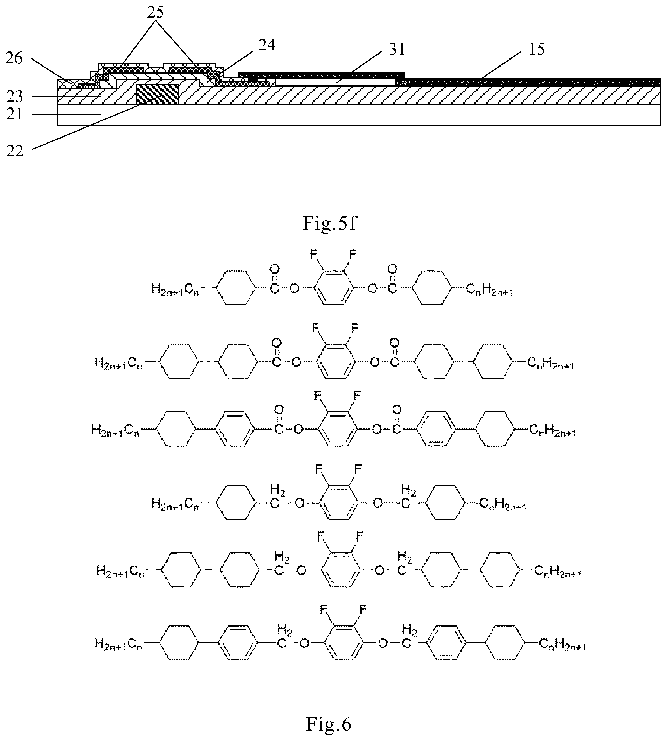

In the embodiment, the liquid crystals in the liquid crystal layer are negative liquid crystals, which may be, for example, fluorine-based derivatives having rigid groups in the molecular structure. In one example, the electron-withdrawing groups in the negative liquid crystals are in the short axis of the liquid crystal molecules. Referring to Fig. 6, in which the molecular formulas of the negative liquid crystals used in the LCD panel according to the embodiment of the invention is shown, the molecular structure includes rigid groups such as biphenyl or biphenyl cyclohexane, the electron-withdrawing groups are in the short axis of the liquid crystal molecules, and the liquid crystal is as a whole negative. The rigid parts of the negative liquid crystal molecule are substantially arranged parallel to each other. However, the centroid of the molecule is not orderly-positioned, thus no lamination structure can be formed, and the liquid crystal molecules can slide up and down, right and left and back and forth. The liquid crystal molecules only remain parallel or quasi-parallel to each other in the long axis and the interaction of the molecules is weak. Due to the inherent property of the liquid crystal molecules, the liquid crystal molecules will rotate when the electron-withdrawing groups are affected by the electric field.

In the LCD panel of the embodiment, the structure of the display is improved by disposing the protrusion on the surface of the color filter substrate facing the liquid crystal layer, and disposing the reflection layer on the surface of the array substrate facing the liquid crystal layer, and arranging the protrusion and the reflection layer opposite to each other. As a result, both lights from the reflective source and the transmissive source experience the same optical path length and the display effect of the LCD monitor is improved.

### Embodiment 2

This embodiment provides a method for fabricating a LCD device, comprising:
Step 10: forming a color filter substrate having a protrusion disposed on a surface of which;
Step 20: forming an array substrate having on a reflection layer disposed on a surface of which; and
Step 30: assembling the color filter substrate and the array substrate to form a cell, so that the protrusion and the reflection layer are opposite to each other, where the height of the protrusion is half the cell gap between the color filter substrate and the array substrate.

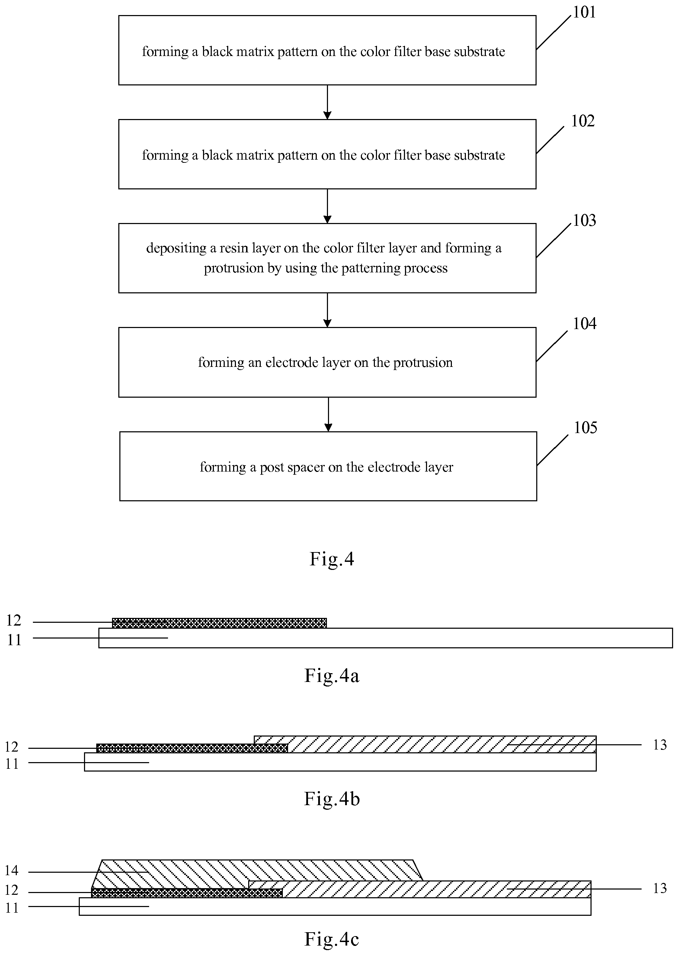

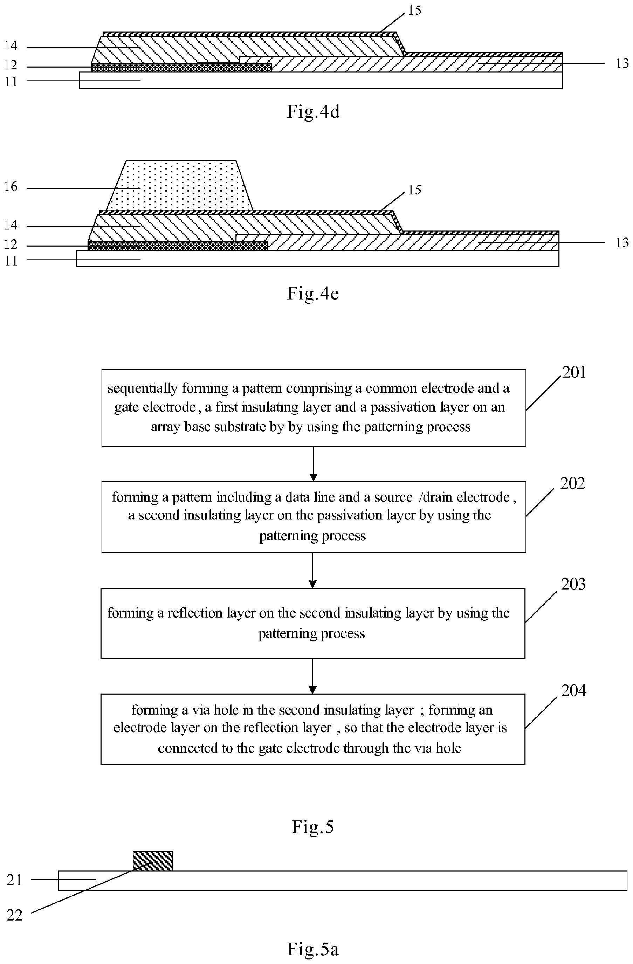

In an example as illustrate in Fig. 4, the step of forming a color filter substrate having a protrusion disposed on a surface of which comprises:
Step 101: forming a black matrix pattern on the color filter base substrate.

For example, a black matrix layer is firstly applied to the color filter base substrate 11 by for example deposition or printing, then the unnecessary black matrix is removed by etching, and the remaining black matrix layer is cured and dried to finally form a black matrix 12 arranged in an array, as illustrated in Fig. 4a, on the surface of the color filter base substrate 11 facing the liquid crystal layer. A material of the black matrix layer may be for example polymer organic resin.

Step 102: forming a color filter layer on the black matrix pattern.

As an example, after the black matrix 12 is formed, pigments are applied to the color filter base substrate 11 by dispersion method, for example, by uniformly applying the pigments and resin on the color filter base substrate using a coating machine. The applied material is then dried to form a film, followed by photolithograph to form a lattice pattern. Finally the color filter layer 13, as illustrated in Fig. 4b, arranged in an array is formed on the surface of the color filter base substrate, facing the liquid crystal layer.

Step 103: depositing a resin layer on the color filter layer and forming a protrusion by using the patterning process.

As an example, after forming the black matrix 12 and the color filter layer 13, a layer of resin is applied to the color filter base substrate 11 and then exposed and developed using a mask plate, such that the resin layer in the exposed region is cured. The resin layer in the unexposed region is then removed to form a protrusion 14 as shown in Fig. 4c. The thickness of the applied resin is half the height of the liquid crystal layer and a material of the resin may be for example polymer organic resin.

Optionally, the step of forming the color filter substrate having a protrusion disposed on a surface of which may further comprises:
Step 104: forming an electrode layer on the protrusion.

As an example, with reference to Fig. 4d, an electrode layer 15 made of for example ITO may be deposited on the surfaces of the protrusion 14 and the color filter layer 13.

Optionally, the step of forming the color filter substrate having a protrusion disposed on a surface of which may further comprises:
Step 105: forming a post spacer on the electrode layer.

As an example, after forming the ITO electrode layer 15, a layer of PS glue is firstly applied on the ITO electrode layer 15 and then exposed by using the patterning process, followed by developing using the developer to form the post spacer 16 as illustrated in Fig. 4e. A material of the post spacer may be, for example, glass fiber or plastic. The post spacer penetrates through the liquid crystal layer, such that the two substrates of the display panel are supported. The thickness of the post spacer is half that of the liquid crystal layer.

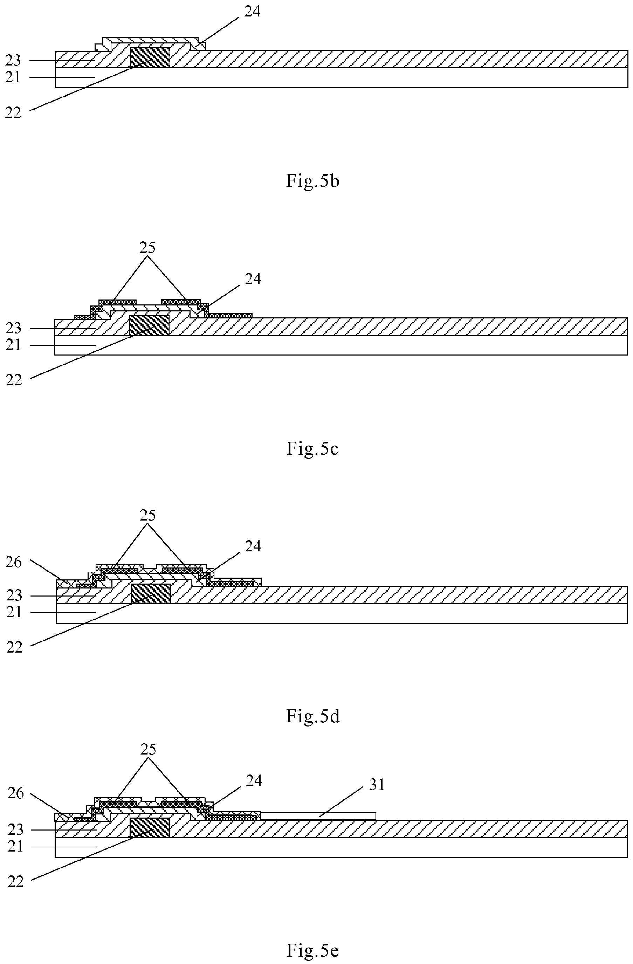

In another example as illustrate in Fig. 5, the step of forming an array substrate having a reflection layer disposed on a surface of which comprises:
Step 201: sequentially forming a pattern comprising a common electrode and a gate electrode, a first insulating layer and a passivation layer on an array base substrate by by using the patterning process.

As an example, a metal layer for the common electrode and the gate electrode is first deposited on the surface of the array base substrate 21 facing the liquid crystal layer by using vapor deposition. A layer of photoresist is applied to the metal layer and then photoresist not necessary for forming the common electrode and the gate electrode is removed via exposing and developing. Next, the metal layer not covered by the photoresist is removed through dry or wet etching. Finally the rest of the photoresist is removed to form a pattern of the common electrode (not shown) and the gate electrode 22 as shown in Fig. 5a.

Next, after forming the gate electrode 22, a first insulating layer 23 is first formed on the surface of the array base substrate 21 facing the liquid crystal layer. The first insulating layer may be deposited by using sputtering. In a high vacuum condition, an insulating material in the plasma state is generated by using glow discharge, thereby forming the first insulating layer on the array base substrate. Vapor disposition is used to deposit a passivation layer on the first insulating layer. Then a photoresist is applied, which is exposed and developed using the mask plate to remove the photoresist unnecessary for forming the passivation layer. Next, etching process is used to remove the passivation layer not covered by the photoresist. Finally, the remaining photoresist is peeled off to form the desired passivation layer 24 as shown in Fig. 5b. A material of the first insulating layer 23 may be for example organic polymer or amorphous silicon and a material of the passivation layer 24 may be for example single-crystal silicon.

Step 202: forming a pattern including a data line and a source/drain electrode, a second insulating layer on the passivation layer by using the patterning process.

As an example, a source/drain electrode metal layer is deposited under high vacuum condition on the surface of the passivation layer 24 facing the liquid crystal layer by using magnetron sputtering. Next, photoresist is applied and then exposed and developed using the mask plate to remove the photoresist not necessary for forming the data line and the source/drain electrode. After that, the metal layer not covered by the photoresist is removed via etching. Finally, the rest of the photoresist is peeled off to form the data line (not shown) and the source/drain electrode 25 as illustrated in Fig. 5c.

Following that, a second insulating layer 26 is deposited on the surface of the source/drain electrode 25 facing the liquid crystal layer. The second insulating layer may be formed via sputtering. Under a high vacuum condition, an insulating material in the plasma state is generated by using glow discharge, thereby forming the second insulating layer. Then a photoresist is applied, which is exposed and developed using the mask plate to remove the photoresist unnecessary for forming the second insulating layer. Next, etching process is used to remove the second insulating layer not covered by the photoresist, so as to peel off the remaining photoresist and form the second insulting layer 26 as shown in Fig. 5d. A material of the second insulating layer 26 may be for example organic polymer or amorphous silicon and the second insulating layer 26 overlays the source/drain electrode 25.

Step 203: forming a reflection layer on the second insulating layer by using the patterning process.

As an example, a metal layer (e.g. an aluminum layer) is deposited under high vacuum codition on the surface of the second insulating layer 26 facing the liquid crystal layer by using magnetron sputtering. Next, photoresist is applied to a surface of the metal aluminum layer and then exposed and developed using the mask plate to remove the photoresist not necessary for forming the reflection layer. After that, the metal layer not covered by the photoresist is removed via etching. Finally, the rest of the photoresist is peeled off to form the reflection layer 31 as illustrated in Fig. 5e. A material of the reflection layer 31 may be for example aluminum. The reflection layer 31 is disposed opposite to the protrusion 14 formed in Step 103.

Optionally, the step of forming the array substrate having a reflection layer disposed on a surface of which may further comprise:
Step 204: forming a via hole in the second insulating layer; forming an electrode layer on the reflection layer, so that the electrode layer is connected to the gate electrode through the via hole.

As an example, a protection layer is applied to the surface of the second insulating layer 26 facing the liquid crystal, and then exposed and developed, followed by etching a via hole in the second insulation layer. The ITO material is sputtered on the surface of the array substrate and then a photoresist is deposited. Photolithography is used to remove the protection layer desired to be removed from the ITO electrode layer. Then the ITO electrode layer is dry or wet etched to remove the ITO electrode not protected by the protection layer and to retain the ITO electrode covered by the protection layer. Finally the protection layer is removed to form the ITO electrode 15 as illustrated in Fig. 5f.

After finishing the fabrication of the color filter substrate and the array substrate, the fabricated color filter substrate and array substrate are assembled in the vacuum to form the liquid crystal cell used by the LCD panel in accordance to Embodiment 1 of the invention. The assembly procedure will be described briefly in the following.

First, the required liquid crystal material is mixed. The required liquid crystal material is negative nematic liquid crystal, the long axis of which is a combination of a benzene ring, a cyclohexane and an ester radical, the electron-withdrawing groups are in the short axis of the liquid crystal molecules and the whole molecule is negative. The mixed liquid crystal is placed in a deaeration device to undergo the deaeration process under the temperature of -20°C∼90°C for 1 to 10 hours.

Next, an alignment agent is applied on both the color filter substrate with the protrusion and the array substrate with the reflection layer, and then rubbed with a flannelette for orientation. The rubbing direction of the first alignment film layer is a direction rotated by 45 degree counterclockwise from the horizontal direction, when the surface of color filter substrate facing the liquid crystal layer is faced upwards. The rubbing direction of the second alignment layer is a direction rotated by 135 degree clockwise from the horizontal direction, when the surface of the array substrate facing the liquid crystal layer is faced upwards.

Next, the mixed and deaerated liquid crystal is dropped to the surface of the array substrate facing the liquid crystal layer, and a sealing glue is applied to the surface of the color filter layer facing the liquid crystal layer, then the array substrate and the color filter substrate are assembled by using vacuum assembly.

Next, the assembled panel is irradiated by UV light having an intensity of 1-100mW/cm² for 5 to 60 minutes. The sealing glue is polymerized under UV irradiation to prevent the diffusion of liquid crystal molecules. Finally, the UV irradiated panel is heated and then tested.

### Embodiment 3

An embodiment of the invention further provides a LCD device comprising the LCD panel in any of the embodiments described above, where the structure and working principle of the LCD panel is the same as those in the above embodiments and will not be described here. Furthermore, please refer to the prior art for the remaining structure of the LCD device, which will not be described here.

The LCD device provided by the embodiment of the invention may be a LCD monitor, a liquid crystal television, a digital photoframe, a mobile phone, a tablet or other product and component having a display function, which is not limited by the invention.

In the LCD panel and its fabrication method and the LCD device in accordance to the embodiments described above, lights from the two different sources are made to travel through equal optical distance by disposing the protrusion on the surface of the color filter substrate facing the liquid crystal layer, and disposing the reflection layer on the surface of the array substrate facing the liquid crystal layer. The LCD panel in accordance with the embodiment of the invention is neat and clever, which optimizes the display performance of the LCD panel and significantly improves the display effect to provide a better user experiences for the customers.

What are described above is related to the illustrative embodiments of the disclosure only and not limitative to the scope of the disclosure; the scopes of the disclosure are defined by the accompanying claims.

## Claims

1. A liquid crystal display (LCD) panel, comprising:
a color filter substrate (10);
an array substrate (20); and
a liquid crystal layer (30) disposed between the color filter substrate (10) and the array substrate (20);
wherein a protrusion (14) is disposed on a surface of the color filter substrate (10) facing the liquid crystal layer (30), and a reflection layer (31) is disposed on a surface of the array substrate (20) facing the liquid crystal layer (30), the protrusion (14) and the reflection layer (31) are disposed opposite to each other;
a first electrode layer (15) is disposed on a surface of the protrusion (14) facing the liquid crystal layer (30) and a second insulating layer (26) is disposed on a surface of a source/ drain electrode (25) facing the liquid crystal layer (39);
a first alignment layer (27) is disposed on the first electrode layer (15);
a second electrode layer (15) and a second alignment layer (28) are sequentially disposed on a surface of the reflection layer (31) and the array substrate (20) facing the liquid crystal layer (30);
a height of the protrusion (14) is half a thickness of the liquid crystal layer (30);
**characterised in that**;
alignment directions of the first and second alignment layers (27, 28) are orthogonal, so that when the power is on, long axes of liquid crystal molecules in the liquid crystal layer (30) are spirally aligned parallel to the color filter substrate (10) and the array substrate (20), and the liquid crystal molecules in a reflective region (R) transform incident circularly polarized light between circularly polarized light and a linear polarized light in a horizontal direction, at the reflection layer (31) and the liquid crystal molecules in a transmissive region (T) transform incident circularly polarized light between left-handed circularly polarized light and a right-handed circularly polarized light.

2. The LCD panel of claim 1, wherein the reflection layer (31) is a metal layer.

3. The LCD panel of claim 2, wherein the metal layer is an aluminium layer.

4. The LCD panel of any of claims 1 - 3, wherein the reflection layer (31) covers a part of the surface of the array substrate (20).

5. The LCD panel of any of claims 1 - 4, wherein liquid crystals in the liquid crystal layer (30) are negative liquid crystals, and electron-withdrawing groups in the negative liquid crystals are in a short axis of the liquid crystals.

6. The LCD panel of claim 5, wherein the negative liquid crystals are fluorine-based derivatives having rigid groups in the molecular structure.

7. The LCD panel of any of claims 1 - 6, wherein the protrusion (14) has a flat surface.

8. A liquid crystal display (LCD) device comprising the LCD panel of any of claims 1 - 7.

9. A method for fabricating an LCD device comprising:
forming a color filter substrate (10) having a protrusion (14) disposed on a surface of which;
forming a first electrode layer (15) on the protrusion (14);
forming a first alignment layer (27) on the first electrode layer (15); forming an array substrate (20) having a reflection layer (31) disposed on a surface of which;
sequentially forming a second electrode layer (15) and a second alignment layer (28) on a surface of the reflection layer (31) and the array substrate (20) facing the liquid crystal layer (30); and
assembling the color filter substrate (10) and the array substrate (20) to form a cell, so that the protrusion (14) and the reflection layer (31) are opposite to each other,
a height of the protrusion (14) is half a cell gap;
charaterised in that;
alignment directions of the first and second alignment layers (27, 28) are orthogonal such that, when the power is on, long axes of liquid crystal molecules in the liquid crystal layer (30) are spirally aligned parallel to the color filter substrate (10) and the array substrate (20), and the liquid crystal molecules in a reflective region (R) transform incident circularly polarized light between circularly polarized light and a linear polarized light in a horizontal direction, and the liquid crystal molecules in a transmissive region (T) transform incident circularly polarized light between left-handed circularly polarized light and right-handed circularly polarized light.

10. The method of claim 9, wherein the step of forming a color filter substrate (10) having a protrusion (14) disposed on a surface of which comprises:
forming a black matrix (12) pattern on a color filter base substrate (11);
forming a color filter layer (13) on the black matrix (12) pattern; and
depositing a resin layer (12) on the color filter layer (13) and forming a protrusion (14) by using the patterning process.

11. The method of claim 9, where the step of forming an array substrate (20) having a reflection layer (31) disposed on a surface of which comprises:
sequentially forming a pattern comprising a common electrode and a gate electrode (22), a first insulating layer (23) and a passivation layer (24) on an array base substrate (21) by using the patterning process;
forming a pattern including data line and a source/ drain electrode (25),
and a second insulating layer (26) on the passivation layer (24) by using the patterning process; and
forming a reflection layer (31) on the second insulating layer (26) by using the patterning process.

12. The method of claim 11, further comprising:
forming a via hole in the second insulating layer (26); and
forming a second electrode layer (15) on the reflection layer (31), the
second electrode layer (15) is connected to the source/ drain electrode (25) through the via hole.

## Patentansprüche

1. Flüssigkristallanzeige (LCD)-Tafel, umfassend:
ein Farbfiltersubstrat (10);
ein Array-Substrat (20); und
eine Flüssigkristallschicht (3), angeordnet zwischen dem Farbfiltersubstrat (10) und dem Array-Substrat (20);
wobei ein Vorsprung (14) auf einer Oberfläche des Farbfiltersubstrats (10), die der Flüssigkristallschicht (30) zugewandt ist, angeordnet ist, und wobei eine Reflektionsschicht (31) auf einer Oberfläche des Array-Substrats (20), die der Flüssigkristallschicht (30) zugewandt ist,
angeordnet ist, wobei der Vorsprung (14) und die Reflektionsschicht (31) gegenüberliegend zueinander angeordnet sind;
wobei eine erste Elektrode (15) auf einer Oberfläche des Vorsprungs (14), die der Flüssigkristallschicht (30) zugewandt ist, angeordnet ist und eine zweite Isolierschicht (26) auf einer Oberfläche einer Source/Drain-Elektrode (25), die der Flüssigkristallschicht (39) zugewandt ist, angeordnet ist;
wobei eine erste Ausrichtungsschicht (27) auf der ersten Elektrode (15) angeordnet ist; wobei eine zweite Elektrodenschicht (15) und eine zweite Ausrichtungsschicht (28) sequenziell angeordnet sind auf einer Oberfläche der Reflektionsschicht (31) und des Array-Substrates (20), der Flüssigkristallschicht (30) zuweisend;
wobei eine Höhe des Vorsprungs (14) der Hälfte einer Dicke der Flüssigkristallschicht (30) entspricht;
**dadurch gekennzeichnet, dass**
die Ausrichtrichtungen der ersten und zweiten Ausrichtungsschichten (27, 28) orthogonal sind, so dass, wenn der Strom eingeschaltet ist, die langen Achsen der Flüssigkristallmoleküle in der Flüssigkristallschicht (30) spiralförmig parallel zu dem Farbfiltersubstrat (10) und dem Array-Substrat (20) ausgerichtet sind, und die Flüssigkristallmoleküle in einer reflektiven Region (R) einfallendes zirkular polarisiertes Licht transformieren zwischen zirkular polarisiertem Licht und einem linear polarisierten Licht in einer horizontalen Richtung bei der Reflektionsschicht (31), und die Flüssigkristallmoleküle in einer transmittierenden Region (T) einfallendes zirkular polarisiertes Licht transformieren zwischen linkshändigem zirkular polarisiertem Licht und einem rechtshändig zirkular polarisiertem Licht.

2. LCD-Tafel gemäß Anspruch 1, wobei die Reflektionsschicht (31) eine Metallschicht ist.

3. LCD-Tafel gemäß Anspruch 2, wobei die Metallschicht eine Aluminiumschicht ist.

4. LCD-Tafel gemäß einem der Ansprüche 1 - 3, wobei die Reflektionsschicht (31) einen Teil der Oberfläche des Array-Substrats (20) bedeckt.

5. LCD-Tafel gemäß einem der Ansprüche 1 - 4, wobei Flüssigkristalle in der Flüssigkristallschicht (30) negative Flüssigkristalle sind, und wobei Elektronen abziehende Gruppen in den negativen Flüssigkristallen in einer kurzen Achse der Flüssigkristalle sind.

6. LCD-Tafel gemäß Anspruch 5, wobei die negativen Flüssigkristalle Fluor-basierende Derivate sind, die feste Gruppen in der Molekularstruktur aufweisen.

7. LCD-Tafel gemäß einem der Ansprüche 1 - 6, wobei der Vorsprung (14) eine flache Oberfläche hat.

8. Flüssigkristallanzeige (LCD)-Vorrichtung, umfassend die LCD-Tafel gemäß einem der Ansprüche 1 - 7.

9. Verfahren zur Herstellung einer LCD-Vorrichtung, umfassend:
Bilden eines Farbfiltersubstrats (10), das einen Vorsprung (14) aufweist, angeordnet auf einer Oberfläche von selbigem;
Bilden einer ersten Elektrodenschicht (15) auf dem Vorsprung (14);
Bilden einer ersten Ausrichtungsschicht (27) auf der ersten Elektrodenschicht (15);
Bilden eines Array-Substrats (20), das eine Reflektionsschicht (31) aufweist, angeordnet auf einer Oberfläche von selbigem;
sequenzielles Bilden einer zweiten Elektrodenschicht (15) und einer zweiten Ausrichtungsschicht (28) auf einer Oberfläche der Reflektionsschicht (31) und des Array-Substrats (20), zugewandt der Flüssigkristallschicht (30); und
Zusammensetzen des Farbfiltersubstrats (10) und des Array-Substrats (20), um eine Zelle zu bilden, so dass der Vorsprung (14) und die Reflektionsschicht (31) einander gegenüber liegen,
wobei eine Höhe des Vorsprungs (14) die Hälfte eines Zellenspalts ist;
**dadurch gekennzeichnet,**
**dass** die Ausrichtungsrichtungen der ersten und zweiten Ausrichtungsschichten (27, 28) orthogonal sind, so dass, wenn der Strom eingeschaltet ist, lange Achsen der Flüssigkristallmoleküle in der Flüssigkristallschicht (30) spiralförmig parallel zu dem Farbfiltersubstrat (10) und dem Array-Substrat (20) ausgerichtet sind, und die Flüssigkristallmoleküle in einer reflektierenden Region (R) einfallendes zirkular polarisiertes Licht transformieren zwischen zirkular polarisierten Licht und einem linear polarisierten Licht in einer horizontalen Richtung, und die Flüssigkristallmoleküle in einer transmittierenden Region (T) einfallendes zirkular polarisiertes Licht transformieren zwischen linkshändigem zirkular polarisiertem Licht und rechtshändig zirkular polarisiertem Licht.

10. Verfahren gemäß Anspruch 9, wobei der Schritt des Bildens eines Farbfiltersubstrats (10), das einen Vorsprung (14) auf einer Oberfläche von selbigem aufweist, umfasst:
Bilden eines Schwarze-Matrix (12)-Musters auf einem Farbfilterbasissubstrat (11); Bilden einer Farbfilterschicht (13) auf dem Schwarze-Matrix (12)-Muster; und Abscheiden einer Harzschicht (12) auf der Farbfilterschicht (13) und Bilden eines Vorsprungs (14) mittels Verwendung des Bemusterungsprozesses.

11. Verfahren gemäß Anspruch 9, wobei der Schritt des Bildens eines Array-Substrats (20), das eine Reflektionsschicht (31) aufweist, die auf einer Oberfläche von selbigem angeordnet ist, umfasst:
sequenzielles Bilden eines Musters, umfassend eine gemeinsame Elektrode und eine Gate-Elektrode (22), eine erste Isolierschicht (23) und eine Passivierungsschicht (24) auf einem Array-Basissubstrat (21) mittels Verwendung des Bemusterungsprozesses;
Bilden eines Musters, das eine Datenleitung und eine Source/Drain-Elektrode (25) und eine zweite Isolierschicht (26) auf der Passivierungsschicht (24) beinhaltet, mittels Verwendung des Bemusterungsprozesses; und
Bilden einer Reflektionsschicht (31) auf der zweiten Isolierschicht (26) mittels Verwendung des Bemusterungsprozesses.

12. Verfahren gemäß Anspruch 11, außerdem umfassend:
Bilden eines Durchgangsloches in der zweiten Isolierschicht (26); und
Bilden einer zweiten Elektrodenschicht (15) auf der Reflektionsschicht (31), wobei die zweite Elektrodenschicht (15) an die Source/DrainElektrode (25) durch das Durchgangsloch angeschlossen ist.

## Revendications

1. Un panneau d'affichage à cristaux liquides (LCD), comprenant :
un substrat de filtre de couleur (10),
un substrat de réseau (20) ; et
une couche de cristaux liquides (30) disposée entre le substrat de filtre de couleur (10) et le substrat de réseau (20) ;
dans lequel une saillie (14) est disposée sur une surface du substrat de filtre de couleur (10) faisant face à la couche de cristaux liquides (30), et une couche de réflexion (31) est disposée sur une surface du substrat de réseau (20) faisant face à la couche de cristaux liquides (30), la saillie (14) et la couche de réflexion (31) sont disposées en regard l'une de l'autre ;
une première couche d'électrode(s) (15) est disposée sur une surface de la saillie (14) faisant face à la couche de cristaux liquides (30) et une deuxième couche d'isolation (26) est disposée sur une surface d'une électrode source/drain (25) faisant face à la couche de cristaux liquides (39) ;
une première couche d'alignement (27) est disposée sur la première couche d'électrode(s) (15) ;
une deuxième couche d'électrode(s) (15) et une deuxième couche d'alignement (28) sont disposées séquentiellement sur une surface de la couche réfléchissante (31) et du substrat de réseau (20) qui fait face à la couche de cristaux liquides (30) ;
une hauteur de la saillie (14) est égale à la moitié d'une épaisseur de la couche de cristaux liquides (30) ;
**caractérisé en ce que** ;
les directions d'alignement des première et deuxième couches d'alignement (27, 28) sont orthogonales de manière que, lors l'alimentation est activée, les axes longs des molécules de cristaux liquides dans la couche de cristaux liquides (30) sont alignés en spirale parallèlement au substrat de filtre de couleur (10) et au substrat de réseau (20), et les molécules de cristaux liquides transforment, dans une région réfléchissante (R), de la lumière incidente polarisée circulairement entre de la lumière polarisée circulairement et une lumière polarisée linéairement dans une direction horizontale, au niveau de la couche réfléchissante (31), et les molécules de cristaux liquides, dans une région transmissive (T), transforment de la lumière incidente polarisée circulairement entre de la lumière polarisée circulairement vers la gauche et une lumière polarisée circulairement vers la droite.

2. Le panneau LCD de la revendication 1, dans lequel la couche de réflexion (31) est une couche métallique.

3. Le panneau LCD de la revendication 2, dans lequel la couche métallique est une couche d'aluminium.

4. Le panneau LCD de l'une quelconque des revendications 1 à 3, dans lequel la couche de réflexion (31) recouvre une partie de la surface du substrat de réseau (20).

5. Le panneau LCD de l'une quelconque des revendications 1 à 4, dans lequel les cristaux liquides dans la couche de cristaux liquides (30) sont des cristaux liquides négatifs, et les groupes électroattracteurs dans les cristaux liquides négatifs sont dans un petit axe des cristaux liquides.

6. Le panneau LCD de la revendication 5, dans lequel les cristaux liquides négatifs sont des dérivés à base de fluor ayant des groupes rigides dans la structure moléculaire.

7. Le panneau LCD de l'une quelconque des revendications 1 à 6, dans lequel la saillie (14) a une surface plate.

8. Un dispositif d'affichage à cristaux liquides (LCD) comprenant le panneau LCD de l'une quelconque des revendications 1 à 7.

9. Un procédé de fabrication d'un dispositif LCD comprenant :
la formation d'un substrat de filtre de couleur (10) comportant une saillie (14) disposée sur une surface de celui-ci ;
la formation d'une première couche d'électrode(s) (15) sur la saillie (14) ;
la formation d'une première couche d'alignement (27) sur la première couche d'électrode(s) (15) ; la formation d'un substrat de réseau (20) ayant une couche de réflexion (31) disposée sur une surface de celui-ci ;
la formation séquentielle d'une deuxième couche d'électrode(s) (15) et d'une deuxième couche d'alignement (28) sur une surface de la couche de réflexion (31) et du substrat de réseau (20) qui fait face à la couche de cristaux liquides (30); et
l'assemblage du substrat de filtre de couleur (10) et du substrat de réseau (20) pour former une cellule, de manière que la saillie (14) et la couche de réflexion (31) soient en regard l'une à l'autre,
une hauteur de la saillie (14) est la moitié d'un espace de cellule ;
**caractérisé en ce que** ;
les directions d'alignement des première et deuxième couches d'alignement (27, 28) sont orthogonales de manière que, lorsque l'alimentation est activée, les axes longs des molécules de cristaux liquides dans la couche de cristaux liquides (30) soient alignés en spirale parallèlement au substrat de filtre de couleur (10) et au substrat de réseau (20), et les molécules de cristaux liquides, dans une région réfléchissante (R), transforment de la lumière incidente polarisée circulairement entre de la lumière polarisée circulairement et une lumière polarisée linéairement dans une direction horizontale, et les molécules de cristaux liquides, dans une région transmissive (T), transforment de la lumière incidente polarisée circulairement entre de la lumière polarisée circulairement vers la gauche et de la lumière polarisée circulairement vers la droite.

10. Le procédé de la revendication 9, dans lequel l'étape de formation d'un substrat de filtre de couleur (10) comportant une saillie (14) disposée sur une surface de celui-ci, comprend : la formation d'un motif de matrice noire (12) sur un substrat de base de filtre de couleur (11) ; la formation d'une couche de filtre de couleur (13) sur le motif de matrice noire (12) ; et le dépôt d'une couche de résine (12) sur la couche de filtre de couleur (13) et la formation d'une saillie (14) en utilisant le procédé de structuration.

11. Le procédé de la revendication 9, dans lequel l'étape de formation d'un substrat de réseau (20) comportant une couche de réflexion (31) disposée sur une surface de celui-ci, comprend : la formation séquentielle d'un motif comprenant une électrode commune et une électrode de grille (22), une première couche isolante (23) et une couche de passivation (24) sur un substrat de base de réseau (21) en utilisant le processus de structuration ;
la formation d'un motif comprenant une ligne de données et une électrode de source/drain (25), et une deuxième couche isolante (26) sur la couche de passivation (24) en utilisant le processus de structuration ; et
la formation d'une couche de réflexion (31) sur la deuxième couche isolante (26) en utilisant le procédé de structuration.

12. Le procédé de la revendication 11, comprenant en outre : la formation d'un trou d'interconnexion dans la deuxième couche d'isolation (26) ; et
la formation d'une deuxième couche d'électrode (15) sur la couche de réflexion (31), la deuxième couche d'électrode (15) est connectée à l'électrode source/drain (25) à travers le trou d'interconnexion.
